# EUROPEAN PATENT APPLICATION

(11) **EP 4 632 971 A1**
(43) Date of publication of application: **15.10.2025**
(21) Application number: 25164091.8
(22) Date of filing: 17.03.2025
(51) Int. Cl.: H01S 3/108, H01S 3/30, H01S 5/14, H01S 5/06, H01S 3/137, H01S 5/0687, H01S 5/10, H01S 3/13

(54) **WIDELY TUNABLE BRILLOUIN LASER BASED ON VERNIER FILTER EXTERNAL CAVITY**

(30) Priority: 11.04.2024 US 202418633434
(71) Applicant: Honeywell International Inc., Charlotte, NC 28202 (US)
(72) Inventor: PUCKETT, Matthew Wade, Charlotte, 28202 (US); HOYT, Chad, Charlotte, 28202 (US); WU, Jianfeng, Charlotte, 28202 (US); NELSON, Karl D., Charlotte, 28202 (US)
(74) Representative: Haseltine Lake Kempner LLP

(57) **Abstract**

Systems and methods for a widely tunable Brillouin laser based on a Vernier filter external cavity are provided herein. In one example, an SBS laser includes a gain chip and external cavity. The external cavity chip includes a first optical waveguide, a first optical resonator optically coupled to the gain chip via the first optical waveguide, a second optical waveguide, and a second optical resonator optically coupled to the first optical resonator via the second optical waveguide. The second optical resonator is configured to generate SBS light from pump light that has propagated through both the first and second optical resonators. The pump light is resonant to both the first and second optical resonators. The SBS light is only resonant to the second optical resonator. The SBS laser is configured to output the SBS light from an output port optically coupled to the second optical resonator.

## Description

### BACKGROUND

Stimulated Brillouin Scattering (SBS) lasers are a powerful technology that offer extremely narrow linewidths, which can be very beneficial for use in optical sensing applications. One of the main shortcomings of SBS lasers, however, is that they traditionally require a pump laser to operate. The pump laser must be actively stabilized to the resonator producing the SBS laser, and the tuning range of the SBS laser is limited to that of the pump laser. In current systems, a pump laser is stabilized to an optical cavity using either a PDH loop or self-injection locking. For a PDH loop, a phase modulator between the pump laser and the SBS resonator is often required as well due to the fairly high frequency modulation. In either case, the stabilization is achieved using an electrically implemented feedback loop, which necessarily increases the complexity of the device and limits its flexibility.

For the reasons above, and for other reasons discussed herein, there is a need for a device that uses a spectrally broad gain medium to directly produce a widely tunable SBS laser without active stabilization of a pump laser.

### SUMMARY

In some aspects, a Stimulated Brillouin Scattering (SBS) laser is described herein. The SBS laser includes a gain chip and an external cavity chip. The external cavity chip includes a first optical waveguide, a first optical resonator optically coupled to the gain chip via the first optical waveguide, a second optical waveguide, and a second optical resonator optically coupled to the first optical resonator via the second optical waveguide. The second optical resonator is configured to generate SBS light from pump light that has propagated through both the first optical resonator and the second optical resonator. The pump light is resonant to both the first optical resonator and the second optical resonator. The SBS light is only resonant to the second optical resonator. The SBS laser is configured to output the SBS light from an output port optically coupled to the second optical resonator.

In some aspects, a system is described herein. The system includes a gain chip and a first optical resonator optically coupled to the gain chip via a first optical waveguide. The system further includes a second optical resonator optically coupled to the first optical resonator via a second optical waveguide. The second optical resonator is configured to generate SBS light from pump light that has propagated through both the first optical resonator and the second optical resonator. The pump light is resonant to both the first optical resonator and the second optical resonator. The SBS light is only resonant to the second optical resonator. The system further includes one or more circuits configured to set a wavelength of the SBS light.

In some aspects, a method is described herein. The method includes generating pump light with a gain chip. The method further includes providing the pump light from the gain chip to an external cavity chip, the external cavity chip comprising a first optical resonator and a second optical resonator. The method further includes generating, using the second optical resonator, Stimulated Brillouin Scattering (SBS) light from pump light that has propagated through both the first optical resonator and the second optical resonator. The pump light is resonant to both the first optical resonator and the second optical resonator. The SBS light is only resonant to the second optical resonator. The method further includes outputting the SBS light from an output port optically coupled to the second optical resonator.

### BRIEF DESCRIPTION OF THE DRAWINGS

Understanding that the drawings depict only some embodiments and are not therefore to be considered limiting in scope, the exemplary embodiments will be described with additional specificity and detail using the accompanying drawings, in which:
FIG. 1 is a diagram of an example SBS laser;
FIG. 2 is a diagram of another example SBS laser;
FIG. 3 is a block diagram of an example system; and
FIG. 4 is a flow diagram of an example method of operation of an SBS laser and system.

In accordance with common practice, the various described features are not drawn to scale but are drawn to emphasize specific features relevant to the example embodiments.

### DETAILED DESCRIPTION

In the following detailed description, reference is made to the accompanying drawings that form a part hereof, and in which are shown by way of illustration specific illustrative embodiments. However, it is to be understood that other embodiments may be utilized, and that logical, mechanical, and electrical changes may be made. Furthermore, the method presented in the drawing figures and the specification is not to be construed as limiting the order in which the individual steps may be performed. The following detailed description is, therefore, not to be taken in a limiting sense.

The techniques described herein produce a widely tunable pump laser simultaneously and automatically generate a Stimulated Brillouin Scattering (SBS) laser by utilizing a dual-resonator Vernier style external cavity chip and a gain chip. The gain chip provides pump light to the external cavity chip, and pump light is resonant to both of the optical resonators, which act as filters to control the wavelength of emission of the pump light. One of the optical resonators is configured to generate SBS light from the pump light that has propagated through both of the optical resonators, and the SBS light is resonant to only the optical resonator that generates it. The SBS light is output from a port of the external cavity chip optically coupled to the optical resonator that generates the SBS light. The SBS light does not propagate back to the gain chip, so a convenient consequence of this design is that the SBS laser is intrinsically insensitive to back-reflection and does not require the use of an external isolator.

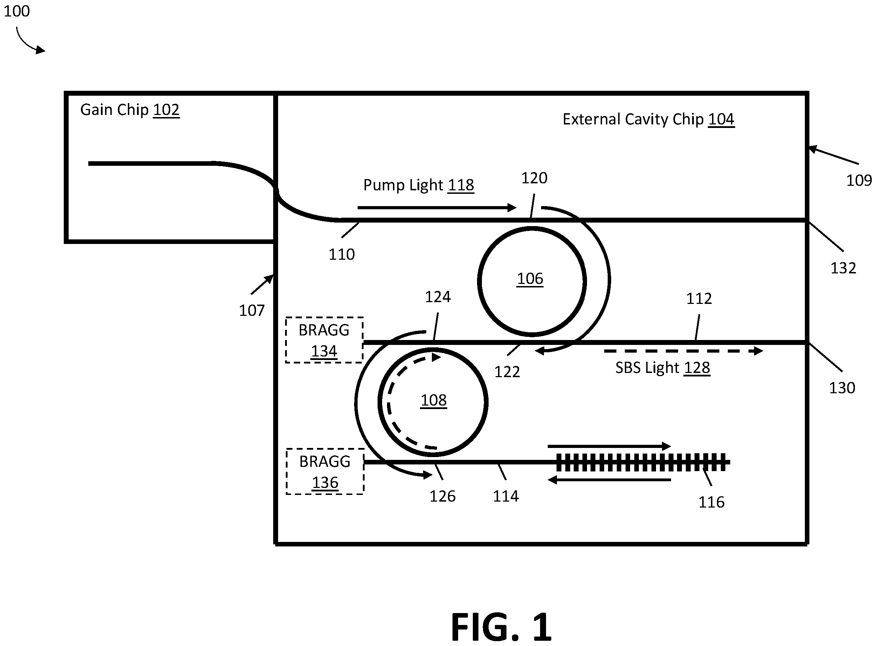

FIG. 1 illustrates a diagram of an example SBS laser 100. In the example shown in FIG. 1, the SBS laser 100 includes various components, including a gain chip 102 and an external cavity chip 104 optically coupled to the gain chip 102. In the example shown in FIG. 1, the external cavity chip 104 includes the first optical resonator 106 and a second optical resonator 108. In some examples, the first optical resonator 106 and the second optical resonator 108 are in a Vernier filtering configuration. In the example shown in FIG. 1, the second optical resonator 108 is configured to operate as an SBS resonator and generate SBS light 128.

The gain chip 102 is configured to generate and provide pump light 118 to the external cavity chip 104. The gain chip 102 is configured to establish an injection lock where the transmission spectrum of the external cavity chip 104 provides optical feedback that propagates back into the gain chip 102 so that the emission wavelength of the pump light 118 from the gain chip 102 naturally locks to one of the resonance frequencies of the first optical resonator 106 and second optical resonator 108 of the external cavity chip 104. The gain chip 102 is configured to generate the pump light 118 with sufficiently high gain such that the Brillouin lasing threshold of the second optical resonator 108 is exceeded. The particular characteristics of the gain chip 102 are determined based on the desired wavelength of operation and the material platform for the SBS laser 100. In some examples, the characteristics of the gain chip 102 are also determined based on the desired linewidth of the SBS laser 100 because the Brillouin lasing threshold increases as the linewidth of the SBS laser 100 narrows. The drive current for the gain chip 102 can be adjusted (for example, using a controller as discussed herein) to produce the pump light 118 at the desired power level such that the power level of the pump light 118 exceeds the Brillouin lasing threshold of the second optical resonator 108.

In some examples, a portion of a first edge 107 of the external cavity chip 104 is coupled to the gain chip 102 using edge coupling. In such examples, the edge of the gain chip 102 and the first edge 107 of the external cavity chip 104 are aligned and fixed in place by epoxy, mounting, or other techniques. In some examples, techniques are used to improve or maximize the coupling efficiency between the gain chip 102 and the external cavity chip 104. For example, the mode profile of the pump light 118 exiting the gain chip 102 can be characterized and an edge coupler (not shown) on the external cavity chip 104 can be designed to mode match such that the mode support on the external cavity chip 104 is more closely matched to the mode profile of the mode coming out of the gain chip 102. In other examples, the external cavity chip 104 is optically coupled to the gain chip 102 using grating couplers or another technique.

In the example shown in FIG. 1, the external cavity chip 104 includes the first optical resonator 106, the second optical resonator 108, a first optical waveguide 110, a second optical waveguide 112, a third optical waveguide 114, and a Bragg grating 116. The first optical waveguide 110 extends from the first edge 107 of the external cavity chip 104, which is coupled to the gain chip 102, to the second edge 109 of the external cavity chip 104, and the second optical waveguide 112 extends from a position offset from the first edge 107 and extends to the second edge 109 of the external cavity chip 104. The first optical resonator 106 is positioned between the first optical waveguide 110 and the second optical waveguide 112. The third optical waveguide 114 extends from a position offset from the first edge 107 of the external cavity chip 104 to the Bragg grating 116 positioned at the other end of the third optical waveguide 114. The second optical resonator 108 is positioned between the second optical waveguide 112 and the third optical waveguide 114 and offset from the Bragg grating 116.

In some examples, the first optical resonator 106, the second optical resonator 108, the core of the optical waveguides 110, 112, 114, and the Bragg grating 116 are formed of the same optical material. In some examples, the optical material is silicon nitride. In other examples, the optical material is silicon, silicon oxynitride, silicon carbide, diamond, or germanium. In some examples, a cladding material (for example, silicon dioxide) with a lower refractive index than the optical material also forms part of the external cavity chip 104. It should be understood that optical materials and cladding materials are examples and that other optical materials could also be used. The external cavity chip 104 can be fabricated using known integrated photonics fabrication techniques.

In the example shown in FIG. 1 and described herein, the first optical resonator 106 and the second optical resonator 108 are implemented as optical ring resonators. In other examples, the first optical resonator 106 and/or the second optical resonator 108 can be implemented as a different type of resonator. For example, the first optical resonator 106 and/or the second optical resonator 108 can be implemented as a racetrack resonator or a Bragg resonator.

In the example shown in FIG. 1, the Brillouin lasing threshold of the second optical resonator 108 is configured to be lower than the Brillouin lasing threshold of the first optical resonator 106. That is, the threshold power of the pump light 118 (and the threshold drive current of the gain chip 102) that is sufficient to induce SBS lasing in the second optical resonator 108 is lower than the threshold power of the pump light 118 (and the threshold drive current of the gain chip 102) that would be sufficient to induce SBS lasing in the first optical resonator 106. In some examples, the Brillouin lasing threshold of the second optical resonator 108 is configured to be substantially lower than the Brillouin lasing threshold of the first optical resonator 106. There are multiple ways to set the Brillouin lasing threshold for the second optical resonator 108 to be lower than the first optical resonator 106.

In some examples, the first optical resonator 106 and the second optical resonator 108 have different radii. The different radii are selected such that the resonances of the first optical resonator 106 and the second optical resonator 108 align at a single wavelength across the spectral range where there is gain and the radius of the first optical resonator 106 is selected so it doesn't operate as an SBS laser. In such examples, the radius of the first optical resonator 106 and the radius of the second optical resonator 108 are selected such that the Brillouin lasing threshold of the second optical resonator 108 is less than the Brillouin lasing threshold of the first optical resonator 106.

In other examples, the first optical resonator 106 and the second optical resonator 108 have the same radius and the temperature of the first optical resonator 106 and the second optical resonator 108 are controlled using one or more circuits (as discussed below) such that the resonances of the first optical resonator 106 and the second optical resonator 108 align at only one wavelength. In such examples, the temperature of the first optical resonator 106 and the temperature of the second optical resonator 108 are selected such that the Brillouin lasing threshold of the second optical resonator 108 is less than the Brillouin lasing threshold of the first optical resonator 106.

In combination with configuring the Brillouin lasing thresholds of the first optical resonator 106 and the second optical resonator 108, a drive current for the gain chip 102 is selected such that only the second optical resonator 108 is lasing. For example, a drive current for the gain chip 102 is selected such that the power level of the pump light 118 will exceed the Brillouin lasing threshold of the second optical resonator 108 but not the Brillouin lasing threshold of the first optical resonator 106.

In the example shown in FIG. 1, the first optical resonator 106 of the external cavity chip 104 is optically coupled to the gain chip 102 via the first optical waveguide 110. In some examples, the external cavity chip 104 includes an output 132 at the second edge 109 of the external cavity chip 104 at the end of the first optical waveguide 110, which can be used to access the pump light 118. In other examples, a Bragg grating can be used to back reflect the pump light 118 or a different feature can be terminate used to terminate the pump light 118 rather than including the output 132.

The first optical resonator 106 is configured to receive pump light 118 from the gain chip 102 via the first optical waveguide 110 at a first coupling region 120. In the example shown in FIG. 1, the pump light 118 is coupled into the first optical resonator 106 at the first coupling region 120 and propagates through the first optical resonator 106 in the clockwise direction.

After propagating through the first optical resonator 106 in the clockwise direction, at least a portion of the pump light 118 is coupled out of the first optical resonator 106 to the second optical waveguide 112 at a second coupling region 122. That pump light 118 is then coupled into the second optical resonator 108 via the second optical waveguide 112 at a third coupling region 124 and propagates through the second optical resonator 108 in the counterclockwise direction.

After propagating through the first optical resonator 106 in the counterclockwise direction, at least a portion of the pump light 118 is coupled out of the second optical resonator 108 to the third optical waveguide 114 at a fourth coupling region 126. That pump light 118 propagates through the third optical waveguide 114 to the Bragg grating 116 and the Bragg grating 116 reflects the pump light 118 back toward the second optical resonator 108 via the third optical waveguide 114. The pump light 118 is then coupled back into the second optical resonator 108 at the fourth coupling region 126 and propagates through the second optical resonator 108 in the clockwise direction.

The first optical resonator 106 and the second optical resonator 108 are configured such that the resonances of the first optical resonator 106 and the second optical resonator 108 align with each other infrequently. In some examples, the first optical resonator 106 and the second optical resonator 108 are configured such that the resonances of the first optical resonator 106 and the second optical resonator 108 align at only one wavelength and don't align at all other wavelengths across a spectral range where there is gain. This infrequent alignment causes feedback to the gain chip 102 only at a doubly resonant wavelength. The pump light 118 is resonant to both the first optical resonator 106 and the second optical resonator 108.

During operation, the first optical resonator 106 and the second optical resonator 108 act as filters to control the wavelength of emission of the pump light 118. In order for the second optical resonator 108 to generate the SBS light 128, the free-spectral range (FSR) set by the radius of the second optical resonator 108 has to correspond to the frequency shift where there is Brillouin scattering. In some examples, the waveguides 110, 112, 114 are operated at 1550 nm. In such examples, if the pump light 118 is provided at one frequency, optical gain can be created at another frequency shifted down about 11 GHz. In order to function as an SBS laser, the FSR is an integer fraction of the Brillouin gain shift (for example, FSR could be 5.5 GHz). When the pump light 118 is at one resonance and another resonance of the second optical resonator 108 aligns with the gain, the second optical resonator 108 generates SBS light 128 when the power level of the pump light 118 is sufficiently high. Accordingly, the second optical resonator 108 is configured to operate as an SBS resonator and generate SBS light 128.

In some examples, the first optical resonator 106 is specifically designed to have a radius with resonances that do not correspond to SBS lasing, and the SBS light 128 is only resonant to the second optical resonator 108. Since the SBS light 128 is only resonant to the second optical resonator 108, the SBS light 128 is routed to output 130 and won't make it back to the gain chip 102 like the pump light 118.

In some examples, additional Bragg gratings 134, 136 can optionally be included to reflect the pump light 118 and/or the SBS light 128 back to the second optical resonator 108. In other examples, the ends of the second optical waveguide 112 and the third optical waveguide 114 where the optional Bragg gratings 134, 136 are shown are instead optically coupled together to route the pump light 118 and/or SBS light 128 back to the second optical resonator 108. In any case, these techniques ensure that the SBS light 128 is only routed to output 130.

It may be desirable to access the SBS light 128 at more than one output. In some examples, one or more of the additional Bragg gratings 134, 136 are omitted and the waveguide extended to the first edge 107 of the external cavity chip 104 such that the SBS light 128 can be output at those locations in addition to output 130. In some examples, the output 130 is replaced with a Bragg grating and the SBS light 128 is accessed at one of the different locations instead.

While the particular example includes the gain chip 102 coupled to the first edge 107 of the external cavity chip 104 and the pump light 118 passing through the first optical resonator 106 and the second optical resonator 108 in particular directions, it should be understood that this is an example and other configurations could also be used. For example, the gain chip 102 could instead be coupled to the second edge 109 of the external cavity chip 104 and the pump light 118 could pass through the first optical resonator 106 and the second optical resonator 108 in the opposite directions.

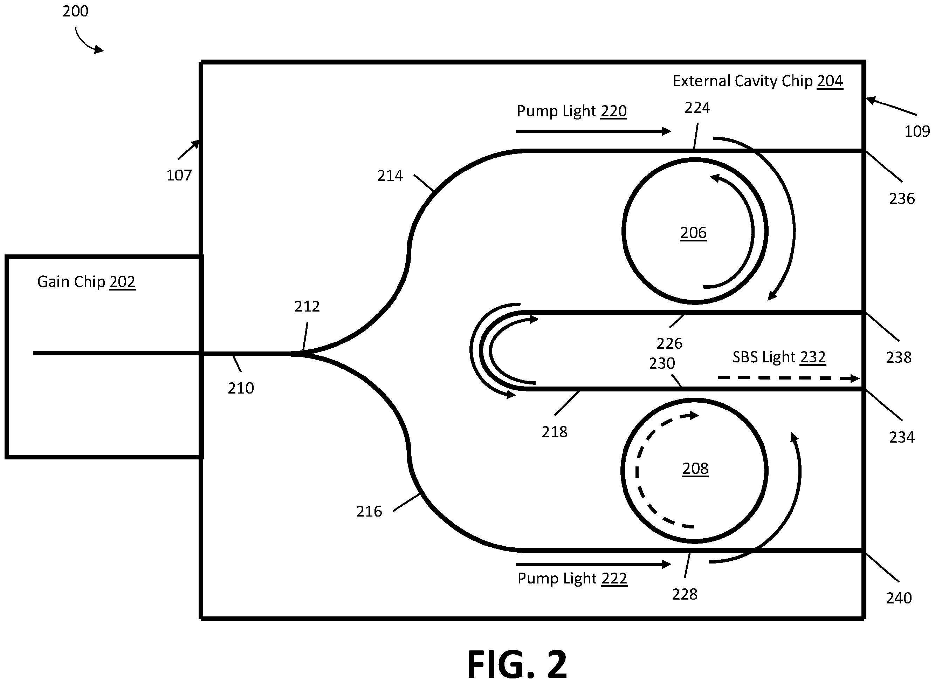

FIG. 2 illustrates a diagram of another example SBS laser 200. In the example shown in FIG. 2, the SBS laser includes various components, including a gain chip 202 and an external cavity chip 204 optically coupled to the gain chip 202. In the example shown in FIG. 1, the external cavity chip 204 includes the first optical resonator 206 and a second optical resonator 208. In some examples, the first optical resonator 206 and the second optical resonator 208 are in a Vernier filtering configuration. In the example shown in FIG. 2, the second optical resonator 208 is configured to operate as an SBS resonator and generate SBS light 232. However, in other examples, the first optical resonator 206 is configured to operate as an SBS resonator and generate SBS light 232. For pedagogical purposes, the description of FIG. 2 below focuses on the examples where the second optical resonator 208 is configured to generate SBS light 232.

The gain chip 202 is configured to generate and provide pump light 220 to the external cavity chip 204. The gain chip 202 is configured to establish an injection lock where the transmission spectrum of the external cavity chip 204 provides optical feedback that propagates back into the gain chip 202 so that the emission wavelength of the pump light 220 from the gain chip 202 naturally locks to one of the resonance frequencies of the first optical resonator 206 and second optical resonator 208 of the external cavity chip 204. The gain chip 202 is configured to generate the pump light 220 with sufficiently high gain such that the Brillouin lasing threshold of the second optical resonator 208 is exceeded. The particular characteristics of the gain chip 202 are determined based on the desired wavelength of operation and the material platform for the SBS laser 200. In some examples, the characteristics of the gain chip 202 are also determined based on the desired linewidth of the SBS laser 200 because the Brillouin lasing threshold increases as the linewidth of the SBS laser 200 narrows. The drive current for the gain chip 202 can be adjusted to produce the pump light 220 at the desired level such that the power level of the pump light 220 exceeds the Brillouin lasing threshold of the second optical resonator 208.

In some examples, a portion of a first edge 207 of the external cavity chip 204 is coupled to the gain chip 202 using edge coupling. In such examples, the edge of the gain chip 102 and the first edge 207 of the external cavity chip 204 are aligned and fixed in place by epoxy, mounting, or other techniques. In some examples, techniques are used to improve or maximize the coupling efficiency between the gain chip 202 and the external cavity chip 204. For example, the mode profile of the pump light 220 exiting the gain chip 202 can be characterized and an edge coupler (not shown) on the external cavity chip 104 can be designed to mode match such that the mode support on the external cavity chip 204 is more closely matched to the mode profile of the mode coming out of the gain chip 202. In other examples, the external cavity chip 204 is optically coupled to the gain chip 202 using grating couplers or another technique.

In the example shown in FIG. 2, the external cavity chip 204 includes the first optical resonator 206, the second optical resonator 208, a first optical waveguide 210, a Splitter 212, a second optical waveguide 214, a third optical waveguide 216, and a fourth optical waveguide 218. The first optical waveguide 210 extends from the first edge 207 of the external cavity chip 204, which is coupled to the gain chip 202, to the splitter 212. From the splitter 212, the second optical waveguide 214 and the third optical waveguide 216 extend to a second edge 209 of the external cavity chip 204. In the example shown in FIG. 2, the second optical waveguide 214 extends from the splitter 212 toward the top of the external cavity chip 204 and the third optical waveguide 216 extends from the splitter 212 toward the bottom of the external cavity chip 204. The fourth optical waveguide 218 extends from the second edge 209 of the external cavity chip 204 toward the first edge 207 and then loops back to the second edge 209. The first optical resonator 206 is positioned between the second optical waveguide 214 and the top portion of the fourth optical waveguide 218, and the second optical resonator 208 is positioned between the third optical waveguide 216 and a bottom portion of the fourth optical waveguide 218.

In some examples, the first optical resonator 206, the second optical resonator 208, the core of the optical waveguides 210, 214, 216, 218, and the splitter 212 are formed of the same optical material. In some examples, the optical material is silicon nitride. In other examples, the optical material is silicon, silicon oxynitride, silicon carbide, diamond, or germanium. In some examples, a cladding material (for example, silicon dioxide) with a lower refractive index than the optical material also forms part of the external cavity chip 204. It should be understood that optical materials and cladding materials are examples and that other optical materials could also be used. The external cavity chip 204 can be fabricated using known integrated photonics fabrication techniques.

In the example shown in FIG. 2 and described herein, the first optical resonator 206 and the second optical resonator 208 are implemented as optical ring resonators. In other examples, the first optical resonator 206 and/or the second optical resonator 208 can be implemented as a different type of resonator. For example, the first optical resonator 206 and/or the second optical resonator 208 can be implemented as a racetrack resonator or a Bragg resonator.

In the example shown in FIG. 2, the Brillouin lasing threshold of the second optical resonator 208 is configured to be lower than the Brillouin lasing threshold of the first optical resonator 206. That is, the threshold power of the pump light 220 (and the threshold drive current of the gain chip 202) that is sufficient to induce SBS lasing in the second optical resonator 208 is lower than the threshold power of the pump light 220 (and the threshold drive current of the gain chip 202) that would be sufficient to induce SBS lasing in the first optical resonator 206. In some examples, the Brillouin lasing threshold of the second optical resonator 208 is configured to be substantially lower than the Brillouin lasing threshold of the first optical resonator 206. There are multiple ways to set the Brillouin lasing threshold for the second optical resonator 208 to be lower than the first optical resonator 206.

In some examples, the first optical resonator 206 and the second optical resonator 208 have different radii. The different radii are selected such that the resonances of the first optical resonator 206 and the second optical resonator 206 align at a single wavelength across the spectral range where there is gain and the radius of the first optical resonator 206 is selected so it doesn't operate as an SBS laser. In such examples, the radius of the first optical resonator 206 and the radius of the second optical resonator 208 are selected such that the Brillouin lasing threshold of the second optical resonator 208 is less than the Brillouin lasing threshold of the first optical resonator 206.

In other examples, the first optical resonator 206 and the second optical resonator 208 have the same radius and the temperature of the first optical resonator 206 and the second optical resonator 208 are controlled using one or more circuits (as discussed below) such that the resonances of the first optical resonator 206 and the second optical resonator 208 align at only one wavelength. In such examples, the temperature of the first optical resonator 206 and the temperature of the second optical resonator 208 are selected such that the Brillouin lasing threshold of the second optical resonator 208 is less than the Brillouin lasing threshold of the first optical resonator 206.

In combination with configuring the Brillouin lasing thresholds of the first optical resonator 206 and the second optical resonator 208, a drive current for the gain chip 202 is selected such that only the second optical resonator 208 is lasing. For example, a drive current for the gain chip 202 is selected such that the power level of the pump light 220 will exceed the Brillouin lasing threshold of the second optical resonator 208 but not the Brillouin lasing threshold of the first optical resonator 206.

In the example shown in FIG. 2, the first optical resonator 206 is optically coupled to the gain chip 202 via the first optical waveguide 210, the splitter 212, and the second optical waveguide 214. In the example shown in FIG. 2, the external cavity chip 204 includes an output 236 at the second edge 209 of the external cavity chip 204 and at the end of the second optical waveguide 214, which can be used to access the pump light 220. In other examples, a Bragg grating can be used to back reflect the pump light 220 or a different feature can be terminate used to terminate the pump light 220 rather than including the output 236.

The pump light 220 generated by the gain chip 202 is provided to the components of the external cavity chip 204 via the first optical waveguide 210 and the splitter 212. The first optical resonator 206 is configured to receive pump light 220 from the gain chip 202 via the second optical waveguide 214 at a first coupling region 224. In the example shown in FIG. 2, the pump light 220 is coupled into the first optical resonator 206 at the first coupling region 224 and propagates through the first optical resonator 206 in the clockwise direction.

After propagating through the first optical resonator 206 in the clockwise direction, at least a portion of the pump light 220 is coupled out of the first optical resonator 206 at a second coupling region 226 and provided to the fourth optical waveguide 218. This pump light 220 that is coupled out of the first optical resonator 206 and provided to the fourth optical waveguide 218 is then coupled into the second optical resonator 208 via the fourth optical waveguide 218 at the fourth coupling region 230. This pump light is coupled into the second optical resonator 208 at the fourth coupling region 230 and propagates through the second optical resonator 208 in the clockwise direction. In some examples, after propagating through the second optical resonator 208 in the clockwise direction, at least a portion of the pump light 220 is coupled out of the second optical resonator 208 at the third coupling region 228 and provided to the gain chip 202 as feedback via the third optical waveguide 216, the splitter 212, and the first optical waveguide 210.

The second optical resonator 208 is also configured to receive pump light 220 from the gain chip 202 via the third optical waveguide 216 at a third coupling region 228. In the example shown in FIG. 2 the pump light 220 is coupled into the second optical resonator 208 at the third coupling region 228 and propagates through the second optical resonator 208 in the counterclockwise direction.

After propagating through the second optical resonator 208 in the counterclockwise direction, at least a portion of the pump light 220 is coupled out of the second optical resonator 208 at a fourth coupling region 230 and provided to the fourth optical waveguide 218. This pump light 220 that is coupled out of the second optical resonator 208 and provided to the fourth optical waveguide 218 is then coupled into the first optical resonator 206 via the fourth optical waveguide 218 at the second coupling region 226. The pump light 220 that is coupled into the first optical resonator 206 at the second coupling region 226 then propagates through the first optical resonator 206 in counterclockwise direction. In some examples, after propagating through the first optical resonator 206 in the counterclockwise direction, at least a portion of the pump light 220 is coupled out of the first optical resonator 206 at the second coupling region 226 and provided to the top portion of the fourth optical waveguide 218 and to an output 238 that can be used to access the pump light 220 at this stage. In other examples, a Bragg grating can be used to back reflect the pump light 220 or a different feature can be terminate used to terminate the pump light 220 rather than including the output 238. In some examples, after propagating through the first optical resonator 206 in the counterclockwise direction, at least a portion of the pump light 220 is coupled out of the first optical resonator 206 at the first coupling region 224 and provided to the gain chip 202 as feedback via the second optical waveguide 214, the splitter 212, and the first optical waveguide 210.

The first optical resonator 206 and the second optical resonator 208 are configured such that the resonances of the first optical resonator 206 and the second optical resonator 208 align with each other infrequently. In some examples, the first optical resonator 206 and the second optical resonator 208 are configured such that the resonances of the first optical resonator 206 and the second optical resonator 208 align at only one wavelength and don't align at all other wavelengths across a spectral range where there is gain. This infrequent alignment causes feedback to the gain chip 202 only at a doubly resonant wavelength. The pump light 220 is resonant to both the first optical resonator 206 and the second optical resonator 208.

During operation, the first optical resonator 206 and the second optical resonator 208 act as filters to control the wavelength of emission of the pump light 220. In order for the second optical resonator 208 to generate the SBS light 232, the free-spectral range (FSR) set by the radius of the second optical resonator 208 has to correspond to the frequency shift where there is Brillouin scattering. In some examples, the waveguides 210, 214, 216, 218 are operated at 1550 nm. In such examples, if the pump light 220 is provided at one frequency, optical gain can be created at another frequency shifted down about 11 GHz. In order to function as an SBS laser, the FSR is an integer fraction of the Brillouin gain shift (for example, FSR could be 5.5 GHz). When the pump light 220 is at one resonance and another resonance of the second optical resonator 208 aligns with the gain, the second optical resonator 208 generates SBS light 232 when the power level of the pump light 220 is sufficiently high. Accordingly, the second optical resonator 208 is configured to operate as an SBS resonator and generate SBS light 232.

In some examples, the first optical resonator 206 is specifically designed to have a radius with resonances that do not correspond to SBS lasing, and the SBS light 232 is only resonant to the second optical resonator 208. Since the SBS light 232 is only resonant to the second optical resonator 208, the SBS light 232 is routed to output 130 rather than back to the gain chip 202 like the pump light 220.

In the example shown in FIG. 2, there is a little more flexibility in the design compared to the SBS laser 100 described above with respect to FIG. 1 in that the Brillouin lasing threshold of either the first optical resonator 206 or the second optical resonator 208 can configured to be lower than the Brillouin lasing threshold of the other optical resonator. In some examples, the Brillouin lasing threshold of the first optical resonator 206 is configured to be lower than the Brillouin lasing threshold of the second optical resonator 208. In other examples, the Brillouin lasing threshold of the second optical resonator 208 is configured to be lower than the Brillouin lasing threshold of the first optical resonator 206.

While the particular example includes the gain chip 202 coupled to the first edge 207 of the external cavity chip 204 and the pump light 220 passing through the first optical resonator 206 and the second optical resonator 108 in particular directions, it should be understood that this is an example and other configurations could also be used. For example, the gain chip 202 could instead be coupled to the second edge 209 of the external cavity chip 204 and the pump light 220 could pass through the first optical resonator 206 and the second optical resonator 208 in the opposite directions.

As described above, the SBS laser 100, 200 operate as a single frequency SBS laser. However, it can be desirable to adjust the wavelength of operation of the SBS laser 100, 200 such that widely tunable SBS laser operation is achieved.

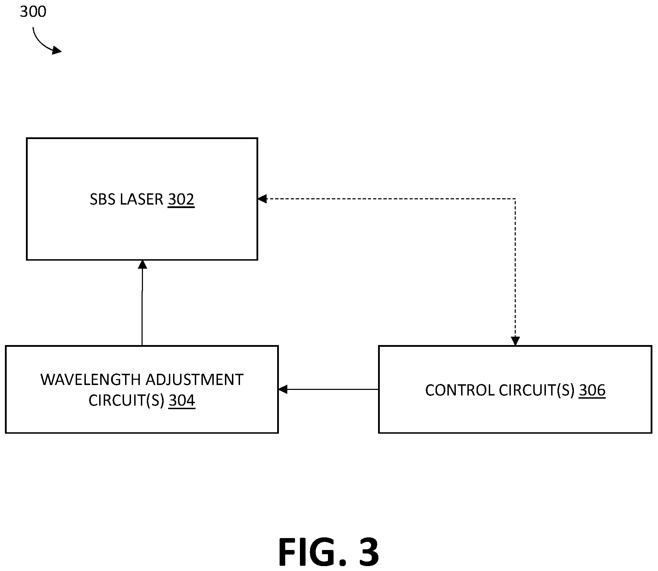

FIG. 3 is a block diagram of an example system 300 where the techniques for SBS laser generation described herein can be utilized. In the example shown in FIG. 3, the system 300 includes an SBS laser 302, one or more wavelength adjustment circuits 304, and one or more controller circuits 306 communicatively coupled to the one or more wavelength adjustment circuits 304.

In some examples, the SBS laser 302 is the SBS laser 100 that includes the gain chip 102 and the external cavity chip 104 described above with respect to FIG. 1. In other examples, the SBS laser 302 is the SBS laser 200 that includes the gain chip 202 and the external cavity chip 204 described above with respect to FIG. 2. Reference numbers to particular features of the SBS laser 302 include the reference numbers for both the SBS laser 100 and the SBS laser 200.

The one or more wavelength adjustment circuits 304 are configured to adjust the wavelength of emission of the SBS light 128, 232. In some examples, the one or more wavelength adjustment circuits 304 are configured to adjust the resonances of the first optical resonator 106, 206 and the second optical resonator 108, 208. In some examples, the one or more wavelength adjustment circuits 304 are configured to adjust the temperature of the first optical resonator 106, 206 and/or the temperature of the second optical resonator 108, 208. In such examples, the one or more wavelength adjustment circuits 304 include heaters that are positioned in close proximity to the first optical resonator 106, 206 and the second optical resonator 108, 208 of the external cavity chip 104, 204. In some examples, the one or more wavelength adjustment circuits 304 include a first circuit that is configured to control the temperature of the first optical resonator 106, 206 and a second circuit that is configured to control the temperature of the second optical resonator 108, 208. In other examples, the one or more wavelength adjustment circuits 304 include a single circuit that is configured to control the temperature of the first optical resonator 106, 206 and the second optical resonator 108, 208. In any case, the temperature of the first optical resonator 106, 206 and the temperature of the second optical resonator 108, 208 are independently controlled.

In some examples, the one or more controller circuits 306 provide control signals to the one or more wavelength adjustment circuits 304 in order to control the adjustment of the wavelength of emission of the SBS light 128, 232. In some examples, the one or more controller circuits 306 include respective controller circuits that are configured to provide control signals to respective one or more wavelength adjustment circuits 304 for adjustment of the temperature of the first optical resonator 106, 206 and the second optical resonator 108, 208. In other examples, the one or more controller circuits 306 includes a single circuit that is configured to provide control signals to the one or more wavelength adjustment circuits 304 for adjustment of the temperature of the first optical resonator 106, 206 and the second optical resonator 108, 208. In some examples, the one or more controller circuits 306 are configured to provide control signals that are based on feedback from the SBS laser 302. For example, the one or more controller circuits 306 are configured to receive an indication of a wavelength of the SBS light 128, 232 output by the SBS laser 302 and provide control signals that are based on the indication of the wavelength of the SBS light 128, 232.

By independently controlling the temperatures of the first optical resonator 106, 206 and the second optical resonator 108, 208, the alignment of resonances of the first optical resonator 106, 206 and the second optical resonator 108, 208 of the external cavity chip 104, 204 can be moved by a relatively large amount. In some examples, the wavelength of emission of the SBS light 128, 232 can be tuned by 10s of nanometers, which is not possible without the use of the first optical resonator 106, 206 and the second optical resonator 108, 208 as described herein.

In some examples, the one or more wavelength adjustment circuits 304 are also configured to adjust operation of the gain chip 102, 202 of the SBS laser 302 in addition to adjusting the temperature of the first optical resonator 106, 206 and/or the second optical resonator 108, 208. In some examples, the one or more wavelength adjustment circuits 304 include a third circuit that is configured to adjust a drive current of the gain chip 102, 202 of the SBS laser 302. In other examples, the one or more controller circuits 306 are directly coupled to the gain chip 102, 202 of the SBS laser 302 and configured to adjust operation of the gain chip 102, 202 (for example, by adjusting the drive current).

While the one or more wavelength adjustment circuits 304 and the one or more controller circuits 306 are shown as separate components in FIG. 3, it should be understood that the one or more wavelength adjustment circuits 304 and the one or more controller circuits 306 can share at least some of the same circuitry in some examples.

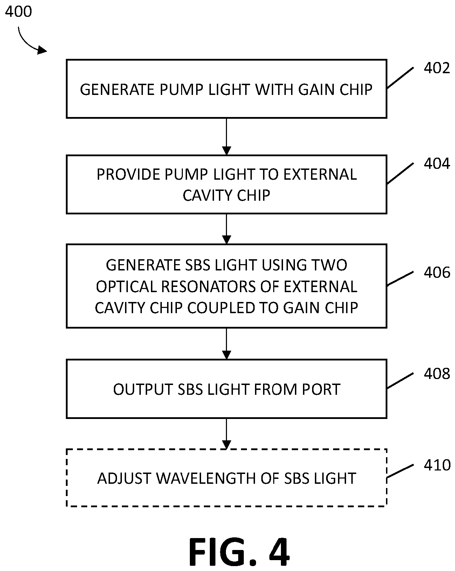

FIG. 4 illustrates a flow diagram of an example method 400 of operation of a SBS laser. The common features discussed above with respect to the example system in FIGS. 1-3B can include similar characteristics to those discussed with respect to method 400 and *vice versa.* In some examples, at least some blocks of the method 400 are performed by an SBS laser (for example, SBS laser 100, 200, 302).

The method 400 includes generating pump light with a gain chip (block 402) and providing the pump light to an external cavity chip (block 404). In some examples, the external cavity chip is edge coupled to the gain chip and includes two optical resonators that are optically coupled via an optical waveguide and an injection lock is established to lock the emission wavelength of the pump light from the gain chip to resonances of the two optical resonators. The pump light is resonant to both of the optical resonators of the external cavity chip.

The method 400 further includes generating SBS light using two optical resonators of an external cavity chip coupled to the gain chip (block 406). In some examples, the two optical resonators are in a Vernier filtering configuration (for example, as described above with respect to FIGS. 1-2). The SBS is generated by only one of the two optical resonators of the external cavity chip from pump light that has propagated through both of the optical resonators. The SBS light is only resonant to the optical resonator that generates the SBS light. In some examples, the radius of the optical resonators is selected such that the Brillouin lasing threshold of the optical resonator that generates the SBS light is lower than the Brillouin lasing threshold of optical resonator that does not generate the SBS light.

The method 400 further includes outputting the SBS light from a port (block 408). In some examples, the port of the external cavity chip that is used for outputting the SBS light can be controlled by using Bragg gratings or by connecting portions optical waveguides to provide SBS light back to the optical resonator that generates the SBS light.

The method 400 optionally includes adjusting a wavelength of the SBS light (block 410). In some examples, adjusting the wavelength of the SBS light includes adjusting the temperature of the optical resonators of the external cavity chip, which adjusts the resonances of the optical resonators. In some examples, adjusting the wavelength of the SBS light also includes adjusting the drive current of the gain chip in order to ensure that the power level of the pump light will only exceed the Brillouin lasing threshold of one of the optical resonators.

By using the Vernier filtering configuration for the optical resonators of the external cavity chip and configuring the optical resonators as described herein, the systems and methods enable generation of SBS light with very narrow linewidth (for example, down to the mHz level depending on the finesse of the optical resonators), without requiring complex control electronics or a phase modulator to lock the pump light to the resonances of the optical resonators. The wavelength of the SBS light can be adjusted (for example, using temperature control of the optical resonators) in order to produce a widely tunable SBS laser. Another advantage of the designs for the SBS lasers described herein is that these SBS lasers are insensitive to back-reflection and do not require the use of an external isolator because the SBS light is only resonant to one of the optical resonators.

In various aspects, system elements, method steps, or examples described throughout this disclosure (such as the system 300 or components thereof, for example) may be implemented on one or more computer systems including a central processing unit (CPU), graphics processing unit (GPU), field programmable gate array (FPGA), application specific integrated circuit (ASIC) and/or similar devices comprising hardware executing code to realize those elements, processes, or examples, said code stored on a non-transient data storage device. These devices include or function with software programs, firmware, or other computer readable instructions for carrying out various methods, process tasks, calculations, and control functions.

These instructions are typically stored on any appropriate computer readable medium used for storage of computer readable instructions or data structures. The computer readable medium can be implemented as any available media that can be accessed by a general purpose or special purpose computer or processor, or any programmable logic device. Suitable processor-readable media may include storage or memory media such as magnetic or optical media. For example, storage or memory media may include conventional hard disks, Compact Disk-Read Only Memory (CD-ROM), volatile or non-volatile media such as Random Access Memory (RAM) (including, but not limited to, Synchronous Dynamic Random Access Memory (SDRAM), Double Data Rate (DDR) RAM, RAMBUS Dynamic RAM (RDRAM), Static RAM (SRAM), etc.), Read Only Memory (ROM), Electrically Erasable Programmable ROM (EEPROM), and flash memory, etc. Suitable processor-readable media may also include transmission media such as electrical, electromagnetic, or digital signals, conveyed via a communication medium such as a network and/or a wireless link.

The methods and techniques described here may be implemented, in part, in digital electronic circuitry, or with a programmable processor (for example, a special-purpose processor or a general-purpose processor such as a computer) firmware, software, or in combinations of them. Apparatus embodying these techniques may include appropriate input and output devices, a programmable processor, and a storage medium tangibly embodying program instructions for execution by the programmable processor. A process embodying these techniques may be performed by a programmable processor executing a program of instructions to perform desired functions by operating on input data and generating appropriate output. The techniques may advantageously be implemented in one or more programs that are executable on a programmable system including at least one programmable processor coupled to receive data and instructions from, and to transmit data and instructions to, a data storage system, at least one input device, and at least one output device. Generally, a processor will receive instructions and data from a read-only memory and/or a random access memory. Storage devices suitable for tangibly embodying computer program instructions and data include all forms of non-volatile memory, including by way of example semiconductor memory devices, such as EPROM, EEPROM, and flash memory devices; magnetic disks such as internal hard disks and removable disks; magneto-optical disks; and DVD disks. Any of the foregoing may be supplemented by, or incorporated in, specially-designed application-specific integrated circuits (ASICs).

### EXAMPLE EMBODIMENTS

Example 1 includes a Stimulated Brillouin Scattering (SBS) laser, comprising: a gain chip; an external cavity chip, wherein the external cavity chip includes: a first optical waveguide; a first optical resonator optically coupled to the gain chip via the first optical waveguide; a second optical waveguide; and a second optical resonator optically coupled to the first optical resonator via the second optical waveguide; wherein the second optical resonator is configured to generate SBS light from pump light that has propagated through both the first optical resonator and the second optical resonator, wherein the pump light is resonant to both the first optical resonator and the second optical resonator, wherein the SBS light is only resonant to the second optical resonator; wherein the SBS laser is configured to output the SBS light from an output port optically coupled to the second optical resonator.

Example 2 includes the SBS laser of Example 1, wherein a radius of the first optical resonator is different than a radius of the second optical resonator.

Example 3 includes the SBS laser of any of Examples 1-2, wherein a temperature of the first optical resonator and/or a temperature of the second optical resonator is selected so resonances of the first optical resonator and resonances of the second optical resonator align infrequently across a spectral range where there is gain.

Example 4 includes the SBS laser of any of Examples 1-3, further comprising a third optical waveguide and a Bragg grating, wherein the first optical resonator is positioned between the first optical waveguide and the second optical waveguide, wherein the second optical resonator is positioned between the second optical waveguide and the third optical waveguide, wherein the third optical waveguide is coupled to the Bragg grating.

Example 5 includes the SBS laser of Example 4, wherein the Bragg grating is configured to reflect light back to the second optical resonator via the third optical waveguide.

Example 6 includes the SBS laser of Example 5, further comprising one or more additional Bragg gratings coupled to the second optical resonator and configured to reflect the SBS light back toward the second optical resonator.

Example 7 includes the SBS laser of any of Examples 1-3, further comprising a splitter and a third optical waveguide, wherein the first optical waveguide and the third optical waveguide extend from the splitter, wherein the first optical resonator is optically coupled to the gain chip via the splitter and the first optical waveguide, wherein the second optical resonator is optically coupled to the gain chip via the third optical waveguide, wherein the first optical resonator is positioned between the first optical waveguide and the second optical waveguide, wherein the second optical resonator is positioned between the second optical waveguide and the third optical waveguide.

Example 8 includes the SBS laser of any of Examples 1-7, wherein the first optical resonator and the second optical resonator are ring resonators.

Example 9 includes the SBS laser of any of Examples 1-8, wherein the first optical resonator and the second optical resonator are racetrack resonators or Bragg resonators.

Example 10 includes the SBS laser of any of Examples 1-9, wherein a Brillouin lasing threshold of the second optical resonator is lower than a Brillouin lasing threshold of the first optical resonator.

Example 11 includes the SBS laser of any of Examples 1-10, wherein the first optical resonator is configured to have a radius with a resonance that does not correspond to SBS lasing.

Example 12 includes a system, comprising: a gain chip; a first optical resonator optically coupled to the gain chip via a first optical waveguide; a second optical resonator optically coupled to the first optical resonator via a second optical waveguide, wherein the second optical resonator is configured to generate SBS light from pump light that has propagated through both the first optical resonator and the second optical resonator, wherein the pump light is resonant to both the first optical resonator and the second optical resonator, wherein the SBS light is only resonant to the second optical resonator; and one or more circuits configured to set a wavelength of the SBS light.

Example 13 includes the system of Example 12, wherein the one or more circuits include a first circuit and a second circuit, wherein the first circuit is configured to adjust a temperature of the first optical resonator, wherein the second circuit is configured to adjust a temperature of the second optical resonator.

Example 14 includes the system of Example 13, wherein the one or more circuits include a third circuit configured to adjust a drive current of the gain chip.

Example 15 includes the system of any of Examples 12-14, wherein a radius of the first optical resonator is different than a radius of the second optical resonator.

Example 16 includes the system of any of Examples 12-15, wherein a Brillouin lasing threshold of the second optical resonator is lower than a Brillouin lasing threshold of the first optical resonator.

Example 17 includes the system of any of Examples 12-16, wherein the one or more circuits are configured to receive an indication of the wavelength of the SBS light, wherein the one or more circuits are configured to adjust a temperature of the first optical resonator, a temperature of the second optical resonator, and/or a drive current of the gain chip based on the indication of the wavelength of the SBS light.

Example 18 includes a method, comprising: generating pump light with a gain chip; providing the pump light from the gain chip to an external cavity chip, the external cavity chip comprising a first optical resonator and a second optical resonator; generating, using the second optical resonator, Stimulated Brillouin Scattering (SBS) light from pump light that has propagated through both the first optical resonator and the second optical resonator, wherein the pump light is resonant to both the first optical resonator and the second optical resonator, wherein the SBS light is only resonant to the second optical resonator; and outputting the SBS light from an output port optically coupled to the second optical resonator.

Example 19 includes the method of Example 18, further comprising adjusting a wavelength of the SBS light.

Example 20 includes the method of any of Examples 18-19, further comprising adjusting a temperature of the first optical resonator, a temperature of the second optical resonator, and/or a drive current of the gain chip.

Although specific embodiments have been illustrated and described herein, it will be appreciated by those of ordinary skill in the art that any arrangement, which is calculated to achieve the same purpose, may be substituted for the specific embodiments shown. Therefore, it is manifestly intended that this invention be limited only by the claims and the equivalents thereof.

## Claims

1. A Stimulated Brillouin Scattering (SBS) laser (100, 200), comprising:
a gain chip (102, 202);
an external cavity chip (104, 204), wherein the external cavity chip (104, 204) includes:
a first optical waveguide (110, 214);
a first optical resonator (106, 206) optically coupled to the gain chip (102, 202) via the first optical waveguide (110, 214);
a second optical waveguide (112, 218); and
a second optical resonator (108, 208) optically coupled to the first optical resonator (106, 206) via the second optical waveguide (112, 218);
wherein the second optical resonator (108, 208) is configured to generate SBS light (128, 232) from pump light (118, 220) that has propagated through both the first optical resonator (106, 206) and the second optical resonator (108, 208), wherein the pump light (118, 220) is resonant to both the first optical resonator (106, 206) and the second optical resonator (108, 208), wherein the SBS light (128, 232) is only resonant to the second optical resonator (108, 208);
wherein the SBS laser (100, 200) is configured to output the SBS light (128, 232) from an output port optically coupled to the second optical resonator (108, 208).

2. The SBS laser (100, 200) of claim 1, wherein a radius of the first optical resonator (106, 206) is different than a radius of the second optical resonator (108, 208), wherein the first optical resonator (106, 206) is configured to have a radius with a resonance that does not correspond to SBS lasing.

3. The SBS laser (100, 200) of any of claims 1-2, wherein a temperature of the first optical resonator (106, 206) and/or a temperature of the second optical resonator (108, 208) is selected so resonances of the first optical resonator (106, 206) and resonances of the second optical resonator (108, 208) align infrequently across a spectral range where there is gain.

4. The SBS laser (100) of any of claims 1-3, further comprising a third optical waveguide (114) and a Bragg grating (116), wherein the first optical resonator (106) is positioned between the first optical waveguide (110) and the second optical waveguide (112), wherein the second optical resonator (108) is positioned between the second optical waveguide (112) and the third optical waveguide, wherein the third optical waveguide is coupled to the Bragg grating.

5. The SBS laser (100, 200) of claim 4, wherein the Bragg grating is configured to reflect light back to the second optical resonator (108) via the third optical waveguide.

6. The SBS laser (100, 200) of any of claims 1-3, further comprising a splitter and a third optical waveguide, wherein the first optical waveguide (214) and the third optical waveguide extend from the splitter, wherein the first optical resonator (206) is optically coupled to the gain chip (202) via the splitter and the first optical waveguide (214), wherein the second optical resonator (208) is optically coupled to the gain chip (202) via the third optical waveguide, wherein the first optical resonator (206) is positioned between the first optical waveguide (214) and the second optical waveguide (218), wherein the second optical resonator (208) is positioned between the second optical waveguide (218) and the third optical waveguide.

7. The SBS laser (100, 200) of claim 1, wherein the first optical resonator (106, 206) and the second optical resonator (108, 208) are ring resonators, racetrack resonators, or Bragg resonators.

8. The SBS laser (100, 200) of claim 1, wherein a Brillouin lasing threshold of the second optical resonator (108, 208) is lower than a Brillouin lasing threshold of the first optical resonator (106, 206).

9. A system (300) including the SBS laser (100, 200) of any of claims 1-8, the system (300) further comprising one or more circuits (304, 306) configured to set a wavelength of the SBS light (128, 232).

10. The system (300) of claim 9, wherein the one or more circuits (304, 306) are configured to receive an indication of the wavelength of the SBS light (128, 232), wherein the one or more circuits (304, 306) are configured to adjust a temperature of the first optical resonator (106, 206), a temperature of the second optical resonator (108, 208), and/or a drive current of the gain chip (102, 202) based on the indication of the wavelength of the SBS light (128, 232).
